# EUROPEAN PATENT APPLICATION

(11) **EP 1 873 914 A1**
(43) Date of publication of application: **02.01.2008**
(21) Application number: 06731237.1
(22) Date of filing: 30.03.2006
(51) Int. Cl.: H03H 9/215, H03H 9/19, H03H 3/02, H01L 41/09, H01L 41/22

(54) **PIEZOELECTRIC VIBRATOR AND MANUFACTURING METHOD THEREOF**

(30) Priority: 30.03.2005 JP 2005099872
(71) Applicant: Seiko Epson Corporation, Tokyo 160-0811 (JP)
(72) Inventor: KURODA, Takahiro, a-shi, Nagano, 3928502 (JP); TANADA, Hideo, a-shi, Nagano, 3928502 (JP)
(74) Representative: HOFFMANN EITLE
(86) International application number: PCT/JP2006/307289
(87) International publication number: WO 2006/104265

(57) **Abstract**

A crystal resonator has a structure in which upper and lower substrates are stacked and integrally and airtightly bonded to the upper and lower surfaces of an intermediate crystal plate. The upper and lower substrates have a concavity on their surfaces facing the intermediate crystal plate to define a cavity in which the crystal resonator element is airtightly sealed in a cantilever manner. The upper and lower bonding surfaces of the intermediate crystal plate are mirror-polished and then provided with a conductive film. Each bonding surface of the upper and lower substrates is a mirror-polished crystal surface.

## Description

### FIELD

The present invention relates to a piezoelectric resonator packaged by airtightly sealing a piezoelectric resonator element operating at a tuning-fork or thickness-shear vibration mode, and a manufacturing method thereof.

### BACKGROUND

Surface-mounted piezoelectric devices, such as crystal resonators, that are suitably mounted on circuit boards or the like have been widely used to respond to demands for smaller and thinner devices as electronic apparatuses are made smaller and thinner. In general, surface-mounted piezoelectric devices have a structure that seals a piezoelectric resonator element in a package made of an insulating material, such as ceramic. However, the related-art package structure, in which a base and a lid are bonded with low-melting glass or by seam welding may lower or deteriorate frequency characteristics of crystal resonator elements due to gas generated by the low-melting glass or high heat for the seam welding. In addition, the low-melting glass is undesirable since it is likely to include lead, which may have an adverse effect on the environment.

To address these issues, JP-A-2000-68780 and JP-A-2002-76826 have proposed a crystal resonator including metal layers on the upper and lower surfaces of an outer frame that are integral with the crystal resonator, and a glass lid and case that are coupled to the metal layers by anode bonding. In the crystal resonator described in JP-A-2000-68780, an electrode extracted from an excitation electrode of a crystal resonator element toward its base portion or outer frame is coupled to an external electrode provided to the lower surface of its case via a through-hole formed in the case. As for the crystal resonator described in JP-A-2002-76826, bonding films are provided on the upper and lower surfaces of the frame of a piezoelectric vibrating plate that are integral with a piezoelectric resonator element. One bonding film on the lower surface of the frame is divided by a portion with no bonding film. The divided bonding film is electrically coupled to the other bonding film on the upper surface of the frame via a contact hole (through-hole), and also to an external electrode provided to the lower surface of a base via a through-hole formed in the base.

JP-A-7-154177 describes a method for manufacturing a piezoelectric device by removing irregularities at the atomic level from mirror-polished bonding surfaces of a piezoelectric plate and a substrate by ultraviolet radiation or oxygen-plasma exposure in an oxygen-containing atmosphere to clean the surfaces, and bonding the piezoelectric plate and the substrate by means of hydrogen bonding of a hydroxyl group generated as a result of moisture adsorption. This bonding method, involving a hydrophilic treatment, is considered to provide high bonding strength through heat treatment of the bonded bodies at 100 degrees centigrade, which is the boiling point of water, or higher.

Furthermore, bonding of materials with different thermal expansion coefficients (e.g., crystal and glass) in a crystal resonator may result in curvature after bonding. To prevent such curvature, JP-A-7-86106 describes a method for compensating for the curvature by sandwiching a first substrate with second and third substrates having almost equivalent thermal expansion coefficients that are different from the coefficient of the first substrate.

Meanwhile, JP-A-10-297931 describes a method for manufacturing a composite piezoelectric substrate by placing a first substrate that is a piezoelectric substrate and a second substrate made of a piezoelectric or other material face-to-face with an organic silicon compound film therebetween, and irradiating them with ultraviolet rays to turn the film into a silicon oxide layer, thereby firmly bonding the substrates. This publication also describes a piezoelectric resonator manufactured by using the above-described method to bond a crystal substrate for a crystal resonator provided with a vibrating part having an excitation electrode and two glass substrates that are second substrates. This piezoelectric resonator is manufactured by irradiating edges of both surfaces of the crystal substrate with ultraviolet rays for surface activation, applying an organic silicon compound film to the edges, and irradiating the film with ultraviolet rays while placing the glass substrates face to face with the film to turn it into an amorphous silicon oxide layer, thereby directly bonding the three substrates.

International Publication No. WO00/76066 discloses a piezoelectric vibrating body, such as a crystal resonator, including a piezoelectric substrate that is a circular crystal plate provided with an electrode film, and crystal protective substrates made of the same crystal material and bonded to both surfaces of the piezoelectric substrate with a bonding part containing gold and silver. The substrates are airtightly bonded by diffusion bonding, that is, by providing a bonding surface provided with an Au film of the piezoelectric substrate and a bonding surface provided with an Ag film of each protective substrate with plasma treatment, applying an even voltage with the substrates stacked, and heating them at 310 degrees centigrade for an hour in a vacuum furnace.

JP-A-2004-304622 describes a surface acoustic wave device manufactured by providing a first metal film on a main surface of a piezoelectric substrate provided with an interdigital transducer (IDT) and an electrode pad to surround the IDT, providing a second metal film in alignment with the first metal film on a main surface of a base substrate, and directly bonding the metal films to stick the both substrates to each other. According to this publication, it is possible to increase the bonding strength of the metal films of the both substrates through surface activation, for example, by ion-beam or plasma radiation at room temperature before bonding, and through pressurizing the two substrates that have been heated at a temperature of about 100 degrees centigrade or lower. Furthermore, JP-A-2004-343359 describes a method for manufacturing a surface acoustic wave device by cleaning a piezoelectric substrate and a supporting substrate to remove impurities from their bonding surfaces, drying the surfaces, irradiating at least one bonding surface with an ion beam, plasma, or the like, to remove residual impurities thereon and activate the superficial layer of the bonding surface, and bonding the piezoelectric substrate and the supporting substrate with the activated bonding surface placed faced to the other bonding surface.

JP-A-2005-311298 discloses a method for bonding a plurality of bonded bodies each having a metal bonding part at room temperature. In this bonding method, the metal bonding parts of the bonded bodies are treated with atom-beam, ion-beam, or plasma energy waves, and then pressurized at a low temperature from room temperature to 180 degrees centigrade, or preferably at room temperature, with the metal bonding parts attached to each other. Here, if the metal bonding parts are particularly made of copper, gold, and aluminum, for example, with a Vickers hardness of 200 Hv or lower, they provide desirable bonding strength. This publication also describes a semiconductor or microelectromechanical system (MEMS) device manufactured by using the bonding method to bond a device with its bonding surface gold-plated to a thickness of 1 µm or more and a lid with its bonding surface provided with a gold thin film.

With the above-mentioned related art package structure for a crystal resonator involving anode bonding, applying a voltage and heating may have adverse effects on a crystal substrate and another substrate bonded thereto. Therefore, it is not necessarily desirable particularly when high accuracy performance is required. Moreover, the structure may generate outer gas like low-melting glass or metal bonding, possibly affecting or deteriorating the characteristics of the crystal resonator.

To make the above-mentioned multilayered sandwich structure by bonding substrates with different thermal expansion coefficients, the substrates have to be stacked to each other all at once. Therefore, the alignment of each substrate of the multilayered structure requires a complicated process that may reduce actual work effectiveness. Moreover, despite an intention to absorb and eliminate the difference in the thermal expansion coefficients of the substrates with the sandwich structure, heat generated at bonding and heat treatment may cause a crack in the intermediate substrate due to the difference in the coefficients or curvature of the whole structure. As a result, substrate bonding conditions such as temperatures are limited, which may make it difficult to secure substantial bonding strength and air-tightness.

With the above-mentioned piezoelectric resonator operating at a tuning-fork or thickness-shear vibration mode, it is necessary to make a high vacuum or inert-gas atmosphere inside the package to maintain low CI values and secure high quality and stability. Therefore, the substrates have to be bonded with high air-tightness to seal the package. Moreover, excessively heating the substrates at bonding may affect the resonating characteristics of the piezoelectric resonator element. As a result, desirable performance may not be achieved.

In the above-mentioned related art method for directly bonding the metal films on the bonding surfaces at a low temperature from room temperature to 180 degrees centigrade, or at 100 degrees centigrade or lower, it takes comparatively long to secure bonding strength that is necessary and sufficient for providing necessary and sufficient air-tightness for the piezoelectric resonator operating at the tuning-fork or thickness-shear vibration mode. Accordingly, the method is of low productivity and unsuitable for industrial applications. Meanwhile, the related art method for bonding substrates while heating them at 300 degrees centigrade take long to make a sufficient vacuum condition in the package, and thus it is also unsuitable for industrial applications.

The above-mentioned related art piezoelectric resonator manufactured by directly bonding the three substrates with a silicon oxide layer therebetween by means of ultraviolet radiation requires a separate wiring structure to extract the excitation electrode of the crystal substrate to the outside of the package, since the bonding portions have no conductivity. Therefore, the whole resonator structure is complicated, which may deteriorate air-tightness.

In consideration of the above-described problems, the present invention aims to provide a piezoelectric resonator including a piezoelectric substrate in which a piezoelectric resonator element made of crystal, for example, and an outer frame that is integral with the element, and upper and lower substrates bonded to the upper and lower surfaces of the piezoelectric substrate to solve the issues of outer gas, moisture corrosion, air-tightness, curvature due to different thermal expansion coefficients and to achieve desirable airtight bonding even with different thermal expansion coefficients.

The invention also aims to provide a method for manufacturing such a piezoelectric resonator easily and economically particularly with easy alignment of the piezoelectric substrate and the upper and lower surfaces.

The invention also aims to provide a piezoelectric resonator capable of maintaining air-tightness that is necessary and sufficient for the resonator with high productivity suitable for industrial mass production, and to provide a manufacturing method thereof.

### SUMMARY

A piezoelectric resonator, according to the present invention includes an intermediate piezoelectric substrate to which a piezoelectric resonator element and an outer frame are integrally formed., At least one of an upper surface and a lower surface of the outer frame is provided with a conductive film.An upper substrate and a lower substrate are bonded to the upper surface and the lower surface, respectively, of the outer frame of the intermediate piezoelectric substrate. The piezoelectric resonator element is suspended in a cantilever manner in a cavity defined by the bonded intermediate piezoelectric substrate and upper and lower substrates and airtightly sealed. Each bonding surface of the upper and lower substrates and the intermediate piezoelectric substrate is mirror-polished and plasma-treated for surface activation, and then stacked to be airtightly bonded.

This multilayered structure of the substrates can make a piezoelectric resonator smaller and thinner than in the related art, and can airtightly bond the upper and lower substrates to the intermediate piezoelectric substrate in a desirable state causing no curvature at room temperature by means of surface activation by plasma treatment. Furthermore, it is advantageous in that no adhesive nor wax material is used unlike related art anode bonding, metal bonding, and low-melting-glass bonding, thereby causing no outer gas that deteriorates the characteristics of the piezoelectric resonator element nor issues of moisture corrosion or air-tightness.

In another aspect, the upper and lower substrates are made of a piezoelectric material. In yet another aspect, the intermediate piezoelectric substrate is made of crystal and the upper and lower substrates are made of the same crystal material, and may be directly bonded to each other. It is therefore possible to eliminate the issue of residual stress due to different thermal expansion coefficients and increase bonding strength. In another aspect, the upper and lower substrates are made of different types of materials such as glass or silicon, and still may be directly bonded at room temperature in a desirable state causing no curvature due to different thermal expansion coefficients.

In still another aspect, the upper and lower surfaces of the outer frame of the intermediate piezoelectric substrate are provided with a conductive film, wherein each bonding surface of the upper and lower substrates is provided with a metal thin film, the conductive film provided to the outer frame and the metal thin film provided to the upper and lower substrates have a top layer made of Au, and the outer frame of the intermediate piezoelectric substrate and the upper and lower substrates are airtightly bonded by diffusion bonding between the conductive film and the metal thin film. The diffusion bonding can provide higher bonding strength and air-tightness.

A method for manufacturing a piezoelectric resonator according to another aspect of the invention includes a step of providing an intermediate piezoelectric substrate to which a piezoelectric resonator element and an outer frame are integrally formed, wherein at least one of an upper surface and a lower surface of the outer frame are provided with a conductive film Steps of providing an upper substrate to be bonded to an upper surface of the intermediate piezoelectric substrate, and providing a lower substrate to be bonded to a lower surface of the intermediate piezoelectric substrate, mirror-polishing each bonding surface of the upper and lower substrates and the intermediate piezoelectric substrate, and providing each mirror-polished bonding surface of the upper and lower substrates and the intermediate piezoelectric substrate with plasma treatment for surface activation are also provided. Lastly, steps of stacking the upper and lower substrates on the upper and lower surfaces of the intermediate piezoelectric substrate in a way that the piezoelectric resonator element is suspended in a cantilever manner in a cavity defined by the substrates, and pressurizing and directly bonding the substrates to airtightly bond the substrates are provided.

It is therefore possible to directly bond the upper and lower substrates and the intermediate piezoelectric substrate and easily and economically make a piezoelectric resonator causing no curvature comparatively smaller and thinner. Since there is no need to apply a voltage unlike the related art anode bonding, the compositions and characteristics of the upper and lower substrates and the intermediate piezoelectric substrate are not affected. Accordingly, the upper and lower substrates can be made of silicon. Moreover, since there is no need to apply a voltage, the method is applicable to an integrated circuit that drives a piezoelectric resonator.

In yet another aspect, the upper and lower substrates may be stacked to the upper and lower surfaces of the intermediate piezoelectric' substrate and pressurized at room temperature or while being heated to bond the substrates. Bonding at room temperature can provide bonding in a desirable state causing no curvature due to different thermal expansion coefficients, even if the intermediate piezoelectric substrate and the upper and lower substrates are made of different types of materials.

In still another aspect, the upper and lower substrates are made of a piezoelectric material. In another aspect, the intermediate piezoelectric substrate is made of crystal and the upper and lower substrates are made of the same crystal material. It is therefore possible to eliminate the issue of residual stress due to different thermal expansion coefficients and increase bonding strength, even if the substrates are bonded while being heated.

In yet another aspect, the upper and lower surfaces of the outer frame of the intermediate piezoelectric substrate is provided with a conductive film, each bonding surface of the upper and lower substrates facing the intermediate piezoelectric substrate is provided with a metal thin film, the conductive film provided to the outer frame and the metal thin film provided to the upper and lower substrates have a top layer made of Au with a thickness of 5000 Å or more, and the outer frame of the intermediate piezoelectric substrate and the upper and lower substrates are directly bonded by metal bonding. This method can bond the substrates with higher bonding strength and air-tightness. In this case, by stacking the upper and lower substrates to the upper and lower surfaces of the intermediate piezoelectric substrate and pressurizing them while being heated, it is possible to bond them for a shorter period of time and with higher bonding strength.

Furthermore, the intermediate piezoelectric substrate and the upper and lower substrates, regardless of being the same or different types of material, can be bonded in a desirable state all at once, or one by one. In still another aspect, the upper and lower substrates are stacked and temporarily bonded to the upper and lower surfaces of the intermediate piezoelectric substrate for alignment, and then the upper and lower surfaces of the substrate stack that has been integrally formed is pressurized to be airtightly bonded. Since the activated surfaces of the substrates by plasma treatment are easily bonded simply by sticking them together, it is possible to easily and accurately align them to each other and thus to increase assembly precision.

In another aspect, after stacking and bonding one of the lower and upper substrates to one of the lower and upper surfaces of the intermediate piezoelectric substrate, the other of the lower and upper substrates is stacked to one of the upper and lower surfaces of the substrate stack and pressurized to be airtightly bonded. The substrates are thus bonded one by one, making it possible to easily align the substrates and increase alignment precision.

In this case, the frequency of the piezoelectric resonator may be adjusted, after stacking and bonding one of the lower and upper substrates to one of the lower and upper surfaces of the intermediate piezoelectric substrate, and before bonding the other of the lower and upper substrates to one of the upper and lower surfaces of the wafer stack. Accordingly, it is possible to efficiently manufacture a high-quality and high-performance piezoelectric resonator. In particular, the frequency of the piezoelectric resonator may be adjusted simultaneously with surface activation of one of the upper and lower surfaces of the substrate stack by providing one of the upper and lower surfaces of the substrate stack with plasma treatment before bonding the other of the lower and upper substrates. Accordingly, it is possible to decrease the number of steps and increase productivity.

A method for manufacturing a piezoelectric resonator according to yet another aspect includes providing an intermediate piezoelectric wafer including the intermediate piezoelectric substrate in a plural number, providing an upper wafer in which the upper substrate is provided in a plural number correspondingly to the intermediate piezoelectric substrate included in the intermediate piezoelectric wafer, providing a lower wafer in which the lower substrate is provided in a plural number correspondingly to the intermediate piezoelectric substrate included in the intermediate piezoelectric wafer, mirror-polishing each bonding surface of the intermediate piezoelectric wafer and the upper and lower wafers, providing each mirror-polished bonding surface of the intermediate piezoelectric wafer and the upper and lower wafers with plasma treatment for surface activation, stacking the upper and lower wafers on upper and lower surfaces of the intermediate piezoelectric wafer and pressurizing the wafers to integrally bonding the wafers, and dividing a wafer stack that has been bonded into individual piezoelectric resonators. Accordingly, a number of piezoelectric resonators can be manufactured all at once, thereby increasing productivity and decreasing cost.

In yet another aspect, in the step of providing the intermediate piezoelectric wafer, a conductive film provided in a portion on at least one of the upper and lower surfaces of the intermediate piezoelectric wafer corresponding to the outer frame of each intermediate piezoelectric substrate is patterned to be divided along a cutting line for dividing the wafer stack into individual piezoelectric resonators and with a gap equal to the width of the cutting line. Accordingly, since the excitation electrode of each piezoelectric resonator is electrically independent in the wafer stack, it is possible to measure or adjust the frequency of the crystal resonator, or carry out a desired test, before dividing the wafer stack into pieces.

### DESCRIPTION OF THE DRAWINGS

Fig. 1A is a side view showing a crystal resonator according to a first embodiment of the invention, Fig. 1B is a longitudinal sectional view thereof, and Fig. 1C is a bottom view thereof.

Fig. 2A is a top view of an intermediate crystal plate shown in Fig. 1, and Fig. 2B is a bottom view thereof.

Fig. 3 is a bottom view of an upper substrate shown in Fig. 1.

Fig. 4 is a top view of a lower substrate shown in Fig. 1.

Fig. 5 is a sectional view of a crystal resonator according to a modification of the first embodiment.

Fig. 6A is a top view of an intermediate crystal plate shown in Fig. 5, and Fig. 6B is a bottom view thereof.

Fig. 7A is a side view showing a crystal resonator according to a second embodiment of the invention, Fig. 7B is a longitudinal sectional view thereof, and Fig. 7C is a bottom view thereof.

Fig. 8A is a top view of an intermediate crystal plate shown in Fig. 7, and Fig. 8B is a bottom view thereof.

Fig. 9 is a bottom view of an upper substrate shown in Fig. 7.

Fig. 10 is a top view of a lower substrate shown in Fig. 7.

Fig. 11 is a schematic perspective view showing three crystal wafers to be bonded in a process to manufacture a crystal resonator by a method according to the invention.

Fig. 12A is a diagram for illustrating a way to bond the three crystal wafers, and Fig. 12B is a schematic perspective view showing a crystal-wafer bonded unit.

Figs. 13A and 13B are diagrams for illustrating another way to bond three crystal wafers.

### DETAILED DESCRIPTION

Preferred embodiments of the invention will now be described with reference to the accompanying drawings.

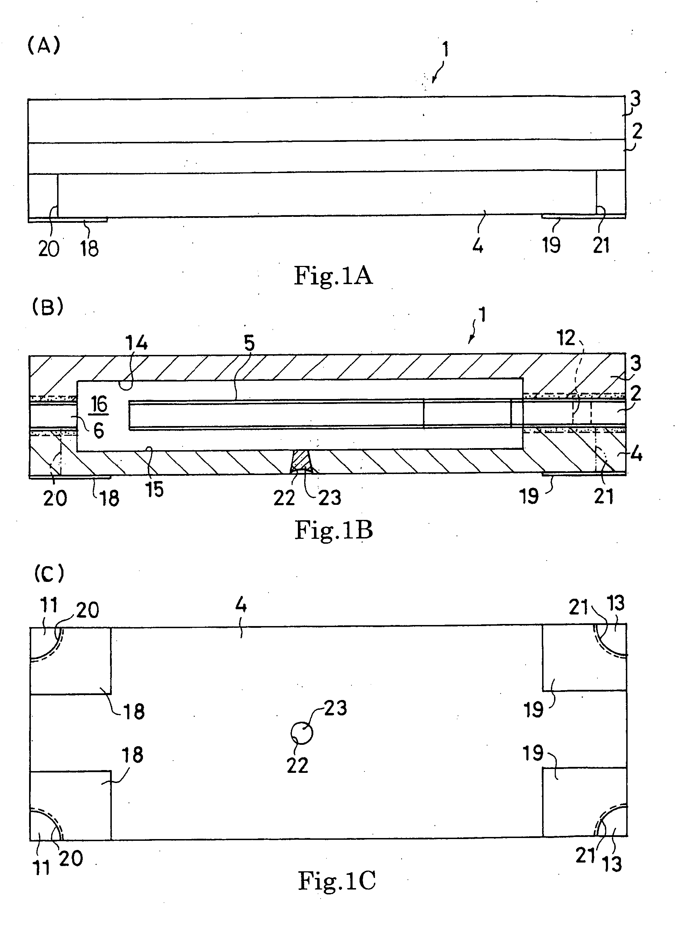

Fig. 1 shows a crystal resonator according to a first embodiment of the invention. Referring to Figs. 1A and 1B, this crystal resonator 1 has a structure in which an upper substrate 3 and a lower substrate 4 are stacked integrally on the upper surface and the lower surface of an intermediate crystal plate 2, respectively. The upper and lower substrates 3 and 4 of the present embodiment are made of the same crystal material as the intermediate crystal plate 2. The intermediate crystal plate 2 and the upper and lower substrates 3 and 4 are directly airtightly bonded, which will be described later.

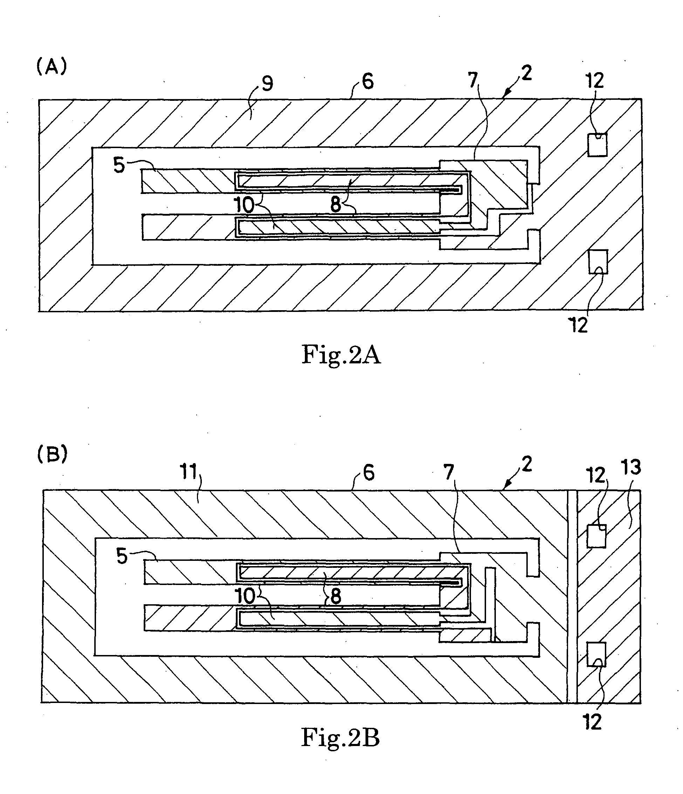

Referring to Figs. 2A and 2B, the intermediate crystal plate 2 is provided with a tuning-fork crystal resonator element 5 and an outer frame 6 that are formed integrally. The crystal resonator element 5 includes a pair of vibrating arms extending from a base portion 7 coupled to the outer frame 6. One excitation electrode 8 provided on their surface is extracted from the base portion 7 and electrically coupled to an upper conductive film 9 provided on the upper surface of the outer frame 6. The other excitation electrode 10 provided on the surface of the vibrating arms is also extracted from the base portion 7 and electrically coupled to a lower conductive film 11 provided on the lower surface of the outer frame 6. Provided at an end of the outer frame 6 coupled to the base portion 7 of the crystal resonator element in the longitudinal direction are two through-holes 12. Provided under the end of the outer frame 6 in the longitudinal direction is an extraction conductive film 13 that is separated from the lower conductive film 11 and electrically coupled to the upper conductive film 9 with a conductive film inside the through-holes 12 therebetween. While the excitation electrode and conductive films are made of aluminum in the present embodiment, they may be made of other conductive materials, such as chromium and titanium.

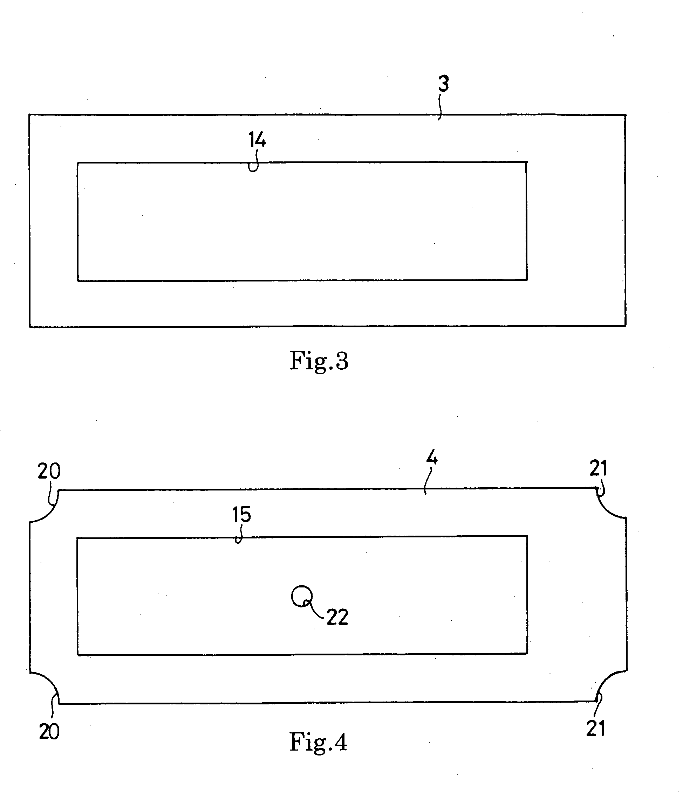

Referring to Figs. 3 and 4, concavities 14 and 15 are formed on the surfaces of the upper and lower substrates 3 and 4, respectively, facing the intermediate crystal plate 2. Housed in a cavity 16 defined by these concavities, the crystal resonator element 5 is suspended by the base portion 7 in a cantilever manner. While the bonding surfaces of the intermediate crystal plate 2, which are the upper and lower surfaces of the outer frame 6, are provided with the conductive films 9 and 11 as mentioned above, the bonding surfaces of the upper and lower substrates 3 and 4, which surround the concavities, have crystal surfaces.

The bonding surfaces of the upper and lower substrates 3 and 4 and the upper and lower bonding surfaces of the outer frame 6 are plasma-treated for surface activation before being bonded. The intermediate crystal plate 2 and the upper and lower substrates 3 and 4 whose bonding surfaces have been activated are stacked in alignment with each other and airtightly bonded with a predetermined voltage in a comparatively short period of time. It is preferable that the intermediate crystal plate and the upper and lower substrates be aligned in a way such that they are in the same plane direction. Thus, the bonding surfaces of the upper and lower substrates 3 and 4 and the upper and lower surfaces of the outer frame 6 are bonded in a desirable state with high air-tightness of a leak of 1 x 10⁻¹⁴ std·cc/sec or higher, for example, so that the cavity is sealed with a high degree of vacuum that is necessary and sufficient for the tuning-fork crystal resonator.

Referring to Fig. 1C, external electrodes 18 and 19 are provided to each corner of the lower surface of the lower substrate 4. Also, there are quarter-round cutouts 20 and 21 at the corners of the lower substrate 4. These cutouts are castellations (circular through-holes) formed at intersections of horizontal and vertical cutting lines for dividing a large crystal plate into individual crystal plates by dicing, for example, and remaining after cutting. A conductive film is provided to the inside of each cutout 20 and 21 to electrically couple the external electrodes 18 and 19 that are adjacent thereto to the lower conductive film 11 and the extraction conductive film 13 of the intermediate crystal plate 2 that are exposed through the cutouts 20 and 21.

At almost the center of the lower substrate 4, a sealing hole 22 is formed to connect the cavity 16 to the outside. The sealing hole 22 is airtightly blocked with a sealant 23 to seal the inside of the cavity 16, which houses the crystal resonator element 5, and maintain a desired vacuum condition or atmosphere. The sealant 23 is a low melting point metal material, such as Au-Sn, and is deposited inside the sealing hole 22 from the outside with laser light, for example. In this case, it is preferable that the inside of the sealing hole 22 be coated with a metal film in advance. Since the amount of outer gas generated while bonding the substrates is relatively small in the present invention, the sealing hole 22 may not be necessary ,and can be omitted.

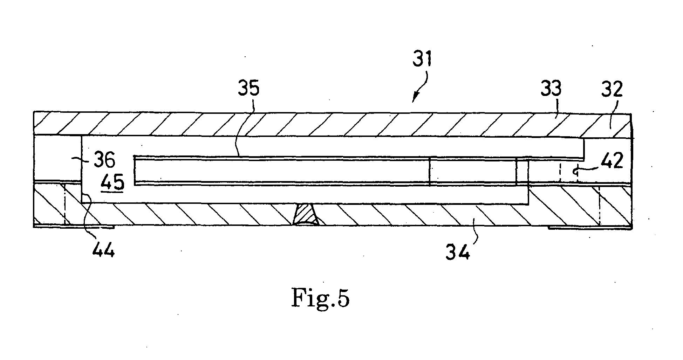

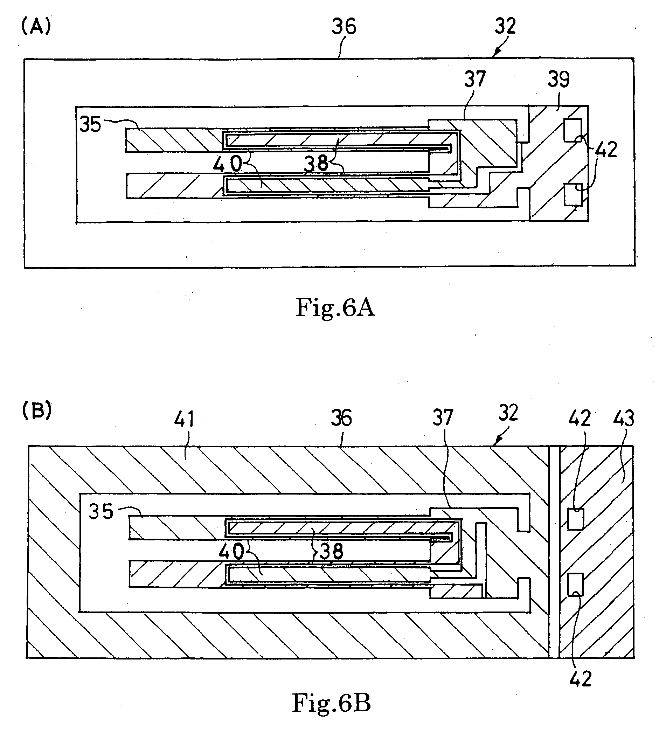

Fig. 5 shows a modification of the first embodiment. As in Fig. 1, a crystal resonator 31 has a structure in which an upper substrate 33 and a lower substrate 34 are integrally stacked to sandwich an intermediate crystal plate 32. Referring to Figs. 6A and 6B, the intermediate crystal plate 32 is provided with a tuning-fork crystal resonator element 35 and an outer frame 36 that are integrally formed, with the following differences from the embodiment shown in Fig. 1. The lower surface of the outer frame 36 is flush with the lower surface of the crystal resonator element 35. The outer frame is made thicker only upward in the thickness direction. At the end of the outer frame 36 coupled to a base portion 37 of the crystal resonator element in the longitudinal direction, there is a step between an inner portion that is adjacent to the base portion 37 and an outer peripheral portion. In other words, while the inner portion has the same height as the crystal resonator element 35 adjacent thereto, the outer peripheral portion has almost the same width and the same thickness as the other portions of the outer frame.

Furthermore, the intermediate crystal plate 32 has no conductive film on the upper surface of the outer frame 36. One excitation electrode 38 provided on the surface of the vibrating arms of the crystal resonator element 35 communicates from the base portion 37 to an upper conductive film 39 provided inside the end of the outer frame 36, having the same height as the base portion, in the longitudinal direction. The other excitation electrode 40, like the intermediate crystal plate 2 shown in Fig. 2, communicates from the base portion to a lower conductive film 41 on the lower surface at the end of the outer frame 36 in the longitudinal direction. Also at the end of the outer frame 36 in the longitudinal direction, through-holes 32 are provided like the first embodiment shown in Fig. 1. With a conductive film provided inside the through-holes, an extraction conductive film 43 provided on the lower surface and separated from the lower conductive film 41 is electrically coupled to the upper conductive film 39 on the upper surface.

Accordingly, in this modification, while the upper substrate 33 is a flat plate having a flat surface facing the intermediate crystal plate 32, the lower substrate 34 has a concavity 44 on its surface facing the intermediate crystal plate 32 like the lower substrate 4 according to the first embodiment. Making multilayer the intermediate crystal plate 32 and the upper and lower substrates 33 and 34 defines a cavity 45 in which the crystal resonator element 35 is suspended by the base portion 37 in a cantilever manner.

The bonding surfaces of the upper and lower substrates 33 and 34 and the bonding surfaces of the outer frame 32, which are the upper and lower surfaces of the outer frame 36, are plasma-treated for surface activation before being bonded like in the above-described embodiment shown in Fig. 1. The intermediate crystal plate 32 and the upper and lower substrates 33 and 34 are stacked in alignment with each other, preferably so that they are in the same plane direction, and bonded directly with a predetermined voltage in a comparatively short period of time. Since the upper substrate 33 and the intermediate crystal plate 32 that are bonded are both made of the same crystal material, a stable bonding condition can be achieved.

According to another modification, the outer frame of the intermediate crystal plate can be made thicker both upward and downward in the thickness direction. In this case, each of the upper and lower surfaces is a flat plate having a flat surface facing the intermediate crystal plate. Here, while the concavity on the surface facing the intermediate crystal plate of each of the upper and lower surfaces can be omitted, making the concavity on the upper and/or lower surfaces can define a larger cavity in which the crystal resonator element is housed. Also in this case, the intermediate crystal plate and the upper and lower substrates whose bonding surfaces have been plasma-treated for surface activation are stacked in alignment with each other and pressurized to be airtightly bonded.

The above-described embodiment is advantageous in that the upper and lower substrates of the crystal resonator are made of the same crystal material as the intermediate crystal plate, and no bonding stress remains unlike bonding of different types of materials with different thermal expansion coefficients. However, materials other than crystal can be used to make the upper and lower substrates according to the invention, as long as the materials can be directly bonded to crystal by plasma treatment according to the invention. Example of such different types of materials may include glass materials, such as Pyrex glass and soda glass, and silicon in particular. In addition to the nature of bonding to crystal, it is preferable that the materials have thermal expansion coefficients that are comparatively close to the coefficient of crystal. Even when the upper and lower substrates are made of such different types of materials, they can be bonded at room temperature according to the present invention, thereby causing no curvature due to different thermal expansion coefficients. With all different thermal expansion coefficients, bonding the three at the same time can prevent curvature due to different thermal expansion coefficients when they are heated to be bonded.

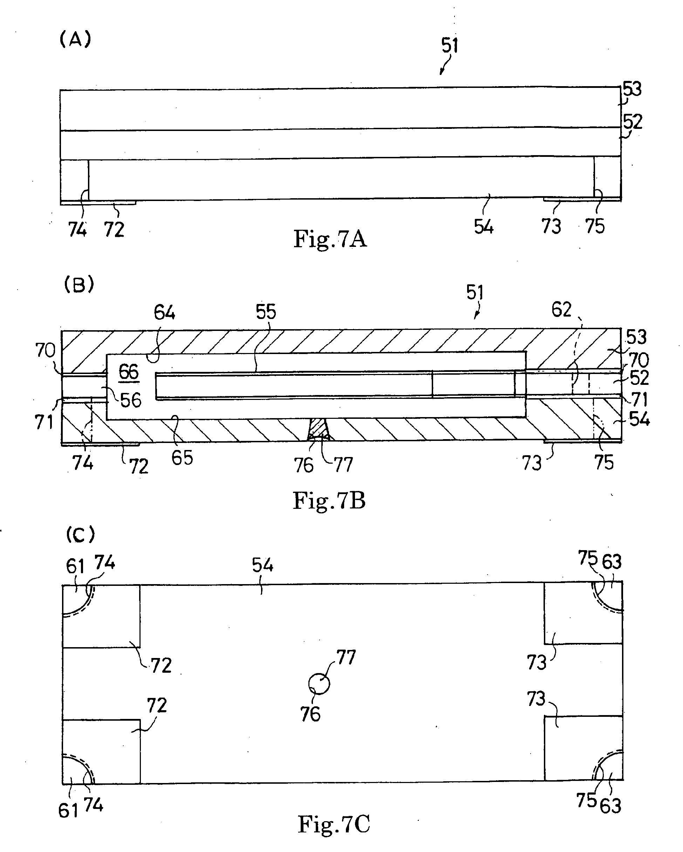

Fig. 7 shows a crystal resonator according to a second embodiment of the invention. Referring to Figs. 7A and 7B, like in the first embodiment, a crystal resonator 51 of the present embodiment has a structure in which an upper substrate 53 and a lower substrate 54 are integrally stacked on the upper surface and the lower surface of an intermediate crystal plate 52, respectively. While the upper and lower substrates 53 and 54 are made of the same crystal material as the intermediate crystal plate 52, they are airtightly bonded to the intermediate crystal plate 52 by means of diffusion bonding of metal films in the present embodiment, as will be described later.

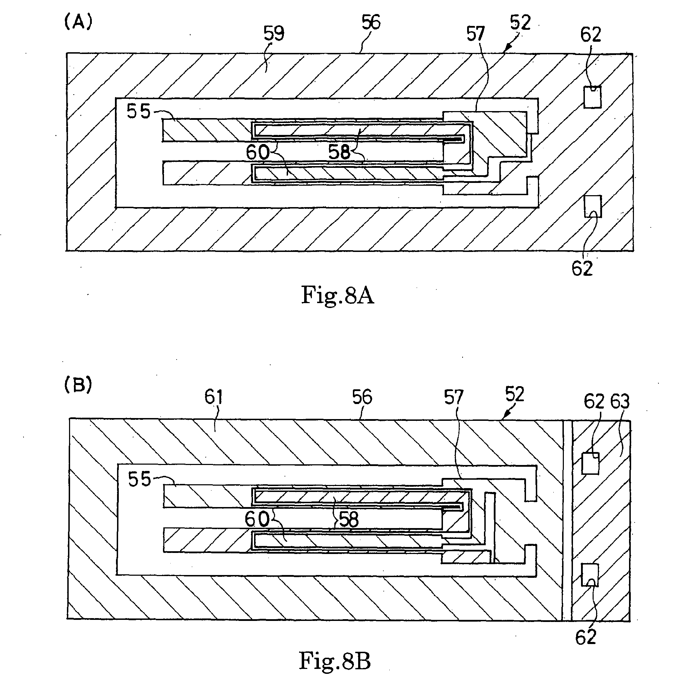

Referring to Figs. 8A and 8B, the crystal resonator 52 is provided with a tuning-fork crystal resonator element 55 and an outer frame 56 that are formed integrally like the intermediate crystal plate shown in Fig. 2. The crystal resonator element 55 includes a pair of vibrating arms extending from a base portion 57 coupled to the outer frame 56. One excitation electrode 58 provided on their surface is extracted from the base portion 57 and electrically coupled to an upper conductive film 59 provided on the upper surface of the outer frame 56. The other excitation electrode 60 provided on the surface of the vibrating arms is also extracted from the base portion 57 and electrically coupled to a lower conductive film 61 provided on the lower surface of the outer frame 56. Provided at an end of the outer frame 56 coupled to the base portion 57 of the crystal resonator element in the longitudinal direction are two through-holes 62. Provided under the end of the outer frame 56 in the longitudinal direction is an extraction conductive film 63 that is separated from the lower conductive film 61 and is electrically coupled to the upper conductive film 59 with a conductive film inside the through-holes 62 therebetween.

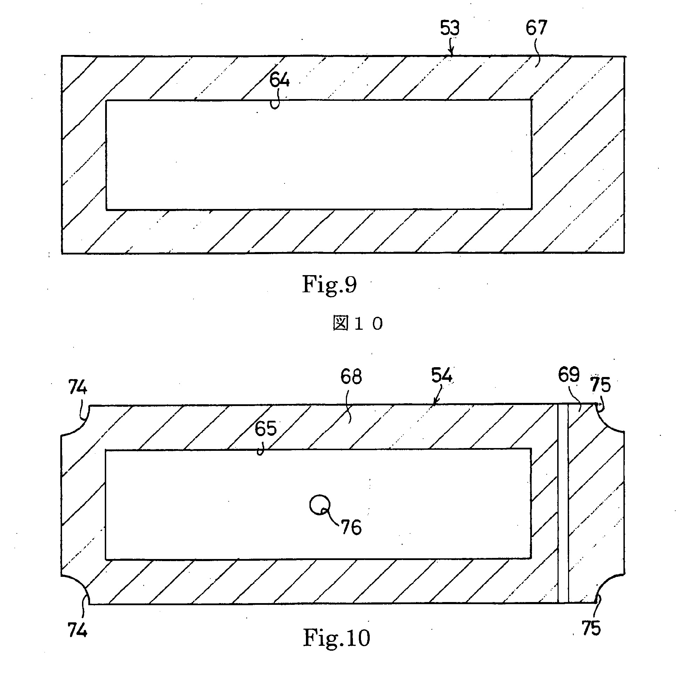

Referring to Figs. 9 and 10, concavities 64 and 65 are formed on the surfaces facing the intermediate crystal plate 52 of the upper and lower substrates 53 and 54, respectively, like the upper and lower substrates shown in Figs. 3 and 4. Housed in a cavity 66 defined by these concavities, the crystal resonator element 55 is suspended by the base portion 57 in a cantilever manner.

Referring to Fig. 9, a metal thin film 67 is provided on the whole bonding surface surrounding the concavity 64 on the lower surface, which faces the intermediate crystal plate 52, of the upper substrate 53. In the same manner, on the bonding surface surrounding the concavity 65 on the upper surface, which faces the intermediate crystal plate 52, of the lower substrate 54, metal thin films 68 and 69 are provided to correspond to the lower conductive film 61 and the extraction conductive film 63 on the lower surface of the intermediate crystal plate.

The metal thin films 67 to 69 are preferably composed of, for example, a foundation layer of Cr, Ni/Cr, Ti, or Ni-Cr, and a top layer of Au. The conductive films 59 and 61 and the extraction conductive film 63 provided on the upper and lower surfaces of the outer frame 56 of the intermediate crystal plate 52 are also preferably composed of, for example, a foundation layer of Cr, Ni/Cr, Ti, or Ni-Cr, and a top layer of Au. The metal films can be easily deposited by a publicly known method, such as sputtering, evaporation, plating and direct plating, or a combination of these methods.

The metal thin films 67 to 69 of the upper and lower substrates 53 and 54 and the conductive films 59, 61, and 63 of the outer frame 56 of the intermediate crystal plate are plasma-treated for surface activation before being bonded. The intermediate crystal plate 52 and the upper and lower substrates 53 and 54 are stacked to in alignment with each other and airtightly bonded at metal bonding parts 70 and 71 by means of diffusion bonding between the metal thin films 67 to 69 and the conductive films 59, 61, and 63 with a predetermined voltage in a comparatively short period of time. It is preferable that the intermediate crystal plate and the upper and lower substrates be aligned in a way that they are in the same plane direction.

In particular, if the top layers, made of Au, of the metal thin films and the conductive films are 5000 Å thick or more, the bonding surfaces of the upper and lower substrates 53 and 54 and the bonding surfaces of the intermediate crystal plate 52, which are the upper and lower surfaces of the outer frame 56, are bonded in a desirable state with high air-tightness of a leak of 1 x 10⁻¹⁴ std·cc/sec or higher, for example, so that the cavity is sealed with a high degree of vacuum that is necessary and sufficient for the tuning-fork crystal resonator. The metal thin films 67 to 69 and the conductive films 59, 61, and 63 desirably have the same thickness, thereby the metal bonding parts 70 and 71 that have a sufficient thickness are available after they are bonded.

Referring to Fig. 7C, external electrodes 72 and 73 are provided to each corner of the lower surface of the lower substrate 54 in the same manner as in the first embodiment. Also, there are quarter-round cutouts 74 and 75 at the corners of the lower substrate 54. These cutouts are castellations (circular through-holes) formed at intersections of horizontal and vertical cutting lines for dividing a large crystal plate into individual crystal plates by dicing, for example, and remaining after cutting. A conductive film is provided to the inside of each cutout 74 and 75 to electrically couple the external electrodes 72 and 73 adjacent thereto to the lower conductive film 61 and the extraction conductive film 63 of the intermediate crystal plate 52 that are exposed through the cutouts 74 and 75.

At almost the center of the lower substrate 54, a sealing hole 76 is formed to connect the cavity 66 to the outside. The sealing hole 76 is airtightly blocked with a sealant 77 to seal the inside of the cavity 66, which houses the crystal resonator element 55, and maintain a desired vacuum condition or atmosphere. The sealant 77 is a low melting point metal material, such as Au-Sn, and is deposited inside the sealing hole 76 from the outside with laser light, for example. In this case, it is preferable that the inside of the sealing hole 76 be coated with a metal film in advance. Also in the present invention, since the amount of outer gas generated while bonding the substrates is relatively small, the sealing hole 76 may not be necessary, and can be omitted.

With the crystal resonator according to the second embodiment, like in the modification of the first embodiment described with reference to Fig. 5, the lower surface of the outer frame 56 of the intermediate crystal plate 52 is flush with the lower surface of the crystal resonator element 55, and the outer frame is made thicker only upward in the thickness direction. There is a step between the base portion 57 of the crystal resonator element and a portion of the outer frame 56 coupled thereto, thereby making the upper substrate flat. Alternatively, the outer frame 56 of the intermediate crystal plate 52 can be made thicker both upward and downward in the thickness direction, and both the upper and lower substrates 53 and 54 can be made flat.

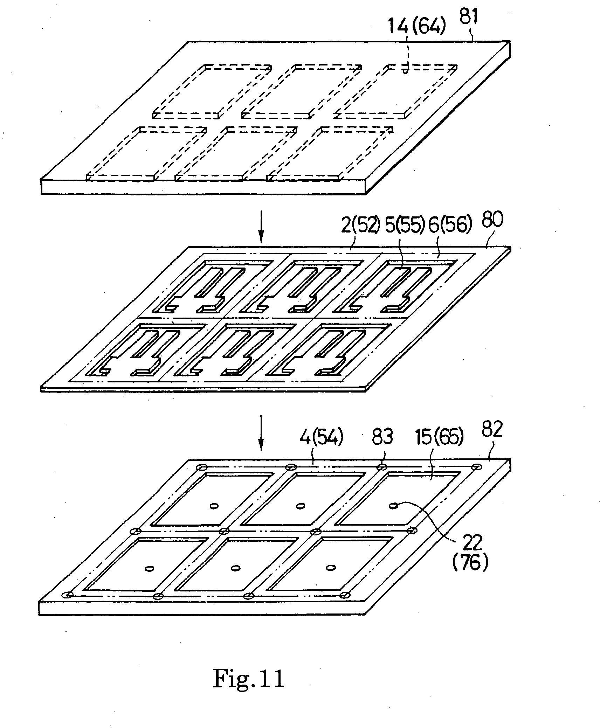

A process to manufacture the crystal resonator of the first embodiment shown in Fig. 1 by a method according to the invention will now be described. As shown in Fig. 11, a large intermediate crystal wafer 80 is prepared in which the crystal resonator element 5 and the outer frame 6 shown in Fig. 1 are provided in a plural number and disposed continuously in both the horizontal and vertical directions. The intermediate crystal wafer 80 is mirror-polished in a way that its upper and lower surfaces preferably have a surface roughness of about several to several dozen nanometers. The outer shapes of the crystal resonator element 5 and the outer frame 6 are formed by etching the crystal wafer by photolithography. On the surfaces of the crystal resonator element 5 and the outer frame 6, a film of a conductive material, such as aluminum, is deposited by sputtering, evaporation, plating, direct plating, or the like, to achieve desirable patterns of the excitation electrode and conductive films.

Along with this, a large upper crystal wafer 81 is prepared in which the upper substrate 3 is provided in a plural number and disposed continuously in both the horizontal and vertical directions. The upper crystal wafer 81 is mirror-polished in a way that at least its lower surface to be bonded to the intermediate crystal wafer 80 preferably has a surface roughness of about several to several dozen nanometers. On the upper crystal wafer 81, the plurality of concavities 14 are formed on the surface facing the intermediate crystal wafer 80 correspondingly to each crystal resonator element 5 and outer frame 6 of the intermediate crystal wafer. The concavities can be easily formed, for example, by etching or sandblasting the surface of the crystal wafer.

In the same manner, a large upper crystal wafer 82 is prepared in which the lower substrate 4 is provided in a plural number and disposed continuously in both the horizontal and vertical directions. The lower crystal wafer 82 is mirror-polished in a way that at least its upper surface to be bonded to the intermediate crystal wafer 80 preferably has a surface roughness of about several to several dozen nanometers. On the lower crystal wafer 82, the plurality of concavities 15 are formed on the surface facing the intermediate crystal wafer 80 correspondingly to each crystal resonator element 5 and outer frame 6 of the intermediate crystal wafer by, for example, etching or sandblasting. Also on the lower crystal wafer 82, the sealing hole 22 is formed at almost the center of each concavity 15, and a circular through-hole 83 is formed at each intersection of the outer lines of the lower substrate 4 that run horizontally and vertically at right angles. On the lower surface of the lower substrate 4, the external electrodes 18 and 19 are provided at predetermined positions in advance by forming a film of a conductive material by sputtering, for example. If the sealant 23 is made of the above-described low melting point metal material, a metal film of the conductive material, for example, is provided in advance inside the sealing hole 22.

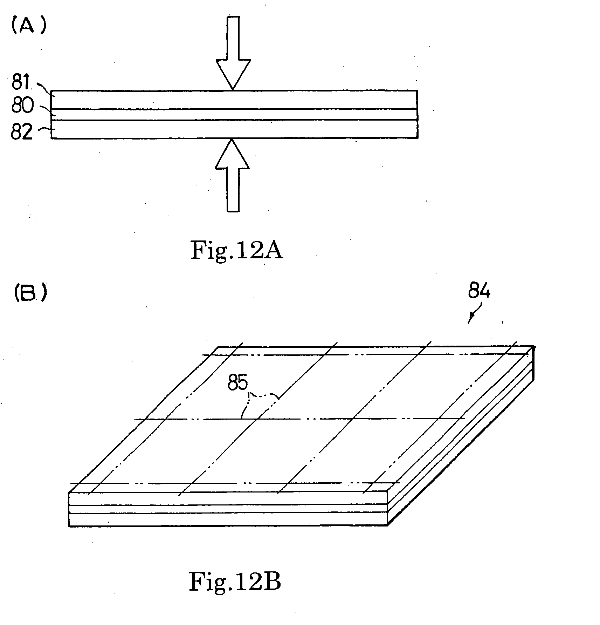

Each of the bonding surfaces of the intermediate crystal wafer 80, the upper crystal wafer 81, and the lower crystal wafer 82 is then plasma-treated for surface activation. After the plasma treatment, the upper and lower surfaces of the intermediate crystal wafer 80 and the upper and lower crystal wafers 81 and 82 are stacked as shown in Fig. 12A. Each of the crystal wafers 80 to 82 is first aligned and their parallelism is adjusted. Then their bonding surfaces are stuck together and temporarily bonded. Then the parallelism of a crystal wafer stack 84 thus structured is preferably readjusted. The wafers are then bonded in a full-fledged manner by pressurizing them from above and below.

The plasma treatment is carried out with a surface-wave-plasma (SWP) reactive-ion-etching (RIE) plasma treatment device that is suitable for processing a large-area wafer, for example. The plasma treatment device includes a stage in a treatment chamber of a high vacuum atmosphere, and the upper, intermediate, and lower crystal wafers to be processed are placed thereon. A desirable reactive gas is introduced into an upper portion of the treatment chamber from an external gas supply. Further provided to the upper portion of the treatment chamber is a wave guide having a slot antenna that is a narrow opening or cutout on its lower surface.

As is well known, microwaves (2.45 GHz) emitted from a microwave oscillator form a standing wave in the wave guide. Microwaves leaked from the slot antenna propagate to a dielectric body, such as a quartz plate placed thereunder, generating a surface wave propagating along the surface. The surface wave generates a plasma that is even at a high concentration on the whole surface of the dielectric body, thereby exciting the reactive gas introduced into the treatment chamber and generating an active species of the reactive gas.

The treatment chamber in operation is continuously provided with the reactive gas from the gas supply, and a predetermined voltage (e.g., 13.56 MHz), is applied to the stage from a high-frequency power source. The active species of the reactive gas generated in the treatment chamber flows from the upper portion downward toward the stage to treat the wafers. This plasma treatment exposes the surfaces of the wafers to the active species of the reactive gas that evenly activates the surfaces. In other words, organic and contaminating substances, or other wastes are etched and removed from the bonding surfaces of the crystal wafers 80 to 82 with ions contained in the plasma. Moreover, the materials of the bonding surfaces are modified by radicals contained in the plasma in a way that atoms with coupling means are exposed. The SWP RIE plasma treatment device can carry out this two-stage plasma treatment in its same chamber consecutively.

According to the present embodiment, for example, CF₄ gas is used as the reactive gas to generate the active species, such as fluorine ions or an excitation species. The state of activation of the plasma-treated wafer surfaces is maintained for at least about an hour. Therefore, the subsequent temporary bonding and full-fledged bonding can be sufficiently carried out. For another embodiment, Ar gas, N₂ gas, a mixed gas of CF₄ and O₂ or of O₂ and N₂, or O₂ gas can be used as the reactive gas to activate the wafer surfaces in the same manner as described above.

Since atoms with coupling means are exposed on each plasma-treated bonding surface of the intermediate crystal wafer 80, the upper crystal wafer 81, and the lower crystal wafer 82, the wafers are easily bonded simply by sticking them together in alignment with each other in the above-mentioned step of temporary bonding. The upper and lower surfaces of the crystal wafer stack 84 that has been temporarily bonded are evenly pressurized at a pressure of about 2 MPa, so that the bonding surfaces are integrally, firmly, and airtightly bonded. According to the present embodiment, this step of full-fledged bonding can be carried out at room temperature. In another embodiment, the step of full-fledged bonding is carried out at a relatively low temperature about 200 to 250 degrees centigrade, so that it has no effect on the characteristics of the crystal resonator element and thus more desirable bonding can be achieved. The stack may be pressurized with a hydraulic or pneumatic device, and may be pressurized while applying supersonic vibration. The temporary bonding and full-fledged bonding of the crystal wafers can be also carried out in an atmospheric pressure, in a desirable inert-gas atmosphere, or in vacuum. In particular, to seal the crystal resonator element 5 in the cavity 16 in high vacuum, it is heated at about 200 to 250 degrees centigrade, followed by vacuum suction for a short period of time of about 20 to 30 minutes to achieve a degree of vacuum of about 10⁻⁵ Torr.

Subsequently, the crystal wafer stack 84 that has been thus bonded is divided into pieces by dicing, for example, along outer lines 85 of the crystal resonator that run horizontally and vertically at right angles as shown in Fig. 12B. It is preferable that the external electrodes 18 and 19 on the bottom surface of the lower substrate 4 be provided by sputtering, for example, to the wafer stack before dicing, which can simplify the process. Since each crystal resonator obtained by dividing the stack into pieces has the upper and lower substrates 3 and 4 that are transparent, it is easily irradiated with laser light, for example, from the outside, thereby adjusting its frequency. Each crystal resonator whose frequency has been adjusted is placed in a vacuum atmosphere to airtightly block the sealing hole 22, which completes the crystal resonator 1 shown in Fig. 1.

According to the present embodiment, it is possible to measure or adjust the frequency of the crystal resonator 1, or carry out a desired test, before dividing the crystal wafer stack 84 into pieces. In this case, the intermediate crystal wafer 80 is patterned in a way that the conductive material of the upper conductive film 9, the lower conductive film 11, and the extraction conductive film 13 provided on the upper and lower surfaces of the outer frame 6 of each adjacent crystal resonator is removed along the outer lines 85 of each crystal resonator and by the width of dicing lines. Accordingly, unlike the above-mentioned anode bonding, the excitation electrode of one crystal resonator 1 is electrically independent from another excitation electrode of an adjacent crystal resonator in the crystal wafer stack 84, making it possible to carry out a characteristic test of each crystal resonator and measure and adjust its frequency.

The upper conductive film 9, the lower conductive film 11, and the extraction conductive film 13 that have been thus patterned are exposed to the side of each crystal resonator 1 obtained by dividing the stack into pieces by dicing. Accordingly, it is possible to prevent moisture from coming into the gap between the bonding surfaces of the substrates at dicing, which may result in electrode corrosion.

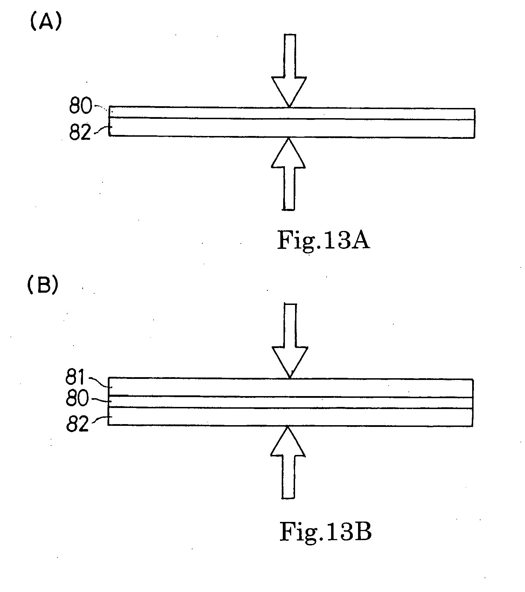

In another embodiment, the three crystal wafers 80 to 81 can be bonded one by one as shown in Fig. 13. Referring to Fig. 13A, the intermediate crystal wafer 80 and the lower crystal wafer 82 are stuck together for temporary bonding. This temporary bonding can be carried out simply by sticking the two wafers together, or by pressurizing them with a smaller pressure than one applied to bond the upper crystal wafer 81 in the subsequent step. Referring now to Fig. 13B, the upper crystal wafer 81 is stacked in alignment with the upper surface of the intermediate crystal wafer 80 and pressurized to be bonded. The pressure applied here is almost as large as one applied in the full-fledged bonding in Fig. 12.

In the present embodiment, the frequency of each crystal resonator element can be adjusted with laser light radiation, for example, in the state shown in Fig. 13A with the two crystal wafers bonded. In this case, the intermediate crystal wafer 80 is patterned in a way that the conductive material of the upper conductive film 9, the lower conductive film 11, and the extraction conductive film 13 of each crystal resonator is removed along the outer lines 85 of each crystal resonator and by the width of dicing lines, so that the excitation electrode of one crystal resonator 1 is electrically independent from an adjacent crystal resonator.

The method according to the present invention is also applicable with the steps shown in Figs. 12 and 13 to provide the crystal resonator 31 of the modification shown in Fig. 5 or to make the outer frame of the intermediate crystal plate thicker than the crystal resonator element both upward and downward in the thickness direction, as well as the embodiment shown in Fig. 1. In such cases, surface activation of each bonding surface is carried out under similar process conditions to the embodiment shown in Fig. 1 with the above-mentioned SWP RIE plasma treatment device, for example. In particular, the upper crystal wafer and/or the lower crystal wafer can be a wafer having flat surfaces on the both sides, which is advantageous in that forming a concavity on their bonding surfaces can be omitted.

Referring back to Fig. 11, a process to manufacture the crystal resonator of the second embodiment shown in Fig. 7 by a method according to the invention will now be described. In the same manner, the large intermediate crystal wafer 80 is prepared in which the crystal resonator element 55 and the outer frame 56 shown in Fig. 7 are provided in a plural number and disposed continuously in both the horizontal and vertical directions. The intermediate crystal wafer 80 is mirror-polished in a way that its upper and lower surfaces preferably have a surface roughness of about several to several dozen nanometers. The outer shapes of the crystal resonator element 55 and the outer frame 56 are formed by etching the crystal wafer by photolithography. On the surfaces of each crystal resonator element and outer frame, a film of a conductive material is deposited by sputtering, evaporation, plating, direct plating, or the like, to achieve desirable patterns of the excitation electrode and conductive films. The conductive films are composed of, for example, a foundation layer of Cr, Ni/Cr, Ti, or Ni-Cr, and a top layer of Au as described above.

Along with this, the large upper crystal wafer 81 is prepared in which the upper substrate 53 is provided in a plural number and disposed continuously in both the horizontal and vertical directions. The upper crystal wafer 81 is mirror-polished in a way that at least its lower surface to be bonded to the intermediate crystal wafer 80 preferably has a surface roughness of about several to several dozen nanometers. On the upper crystal wafer 81, the plurality of concavities 64 are formed on the surface facing the intermediate crystal wafer 80 correspondingly to each crystal resonator element 55 and outer frame 56 of the intermediate crystal wafer by, for example, etching or sandblasting.

Further on the upper crystal wafer 81, a metal thin film is provided on its bonding surface facing the intermediate crystal plate 80, which is its whole lower surface surrounding the concavities 64. The metal thin film is composed of, for example, a foundation layer of Cr, Ni/Cr, Ti, or Ni-Cr, and a top layer of Au by a method, such as sputtering, evaporation, plating and direct plating, or a combination of these methods. The layer of Au is preferably provided to a thickness of 5000 Å or more as described above.

In the same manner, the large lower crystal wafer 82 is prepared in which the lower substrate 54 is provided in a plural number and disposed continuously in both the horizontal and vertical directions. The lower crystal wafer 82 is mirror-polished in a way that at least its upper surface to be bonded to the intermediate crystal wafer 80 preferably has a surface roughness of about several to several dozen nanometers. On the lower crystal wafer 82, the plurality of concavities 65 are formed on the surface facing the intermediate crystal wafer 80 correspondingly to each crystal resonator element 55 and outer frame 56 of the intermediate crystal wafer by etching or sandblasting. Also on the lower crystal wafer 82, the sealing hole 75 is thoroughly formed at almost the center of each concavity 65, and the circular through-hole 83 is formed at each intersection of the outer lines of the lower substrate 54 that run horizontally and vertically at right angles.

Further on the lower crystal wafer 82, a metal thin film is provided on its bonding surface facing the intermediate crystal plate 80, which is its whole upper surface surrounding the concavity 65. The metal thin film is composed of, for example, a foundation layer of Cr, Ni/Cr, Ti, or Ni-Cr, and a top layer of Au by a publicly known method, such as sputtering, evaporation, plating and direct plating, or a combination of these methods. The layer of Au is preferably Provided to a thickness of 5000 Å or more as described above.

On the lower surface of the lower substrate 4, the plurality of external electrodes 72 and 73 are provided at predetermined positions in advance by forming a film of a conductive material by sputtering, for example. If the sealant 77 is made of the above-described low melting point metal material, a metal film of the conductive material, for example, is provided in advance inside the sealing hole 75.

Each of the bonding surfaces of the intermediate crystal wafer 80, the upper crystal wafer 81, and the lower crystal wafer 82 is then plasma-treated for surface activation. After the plasma treatment, the upper and lower surfaces of the intermediate crystal wafer 80 and the upper and lower crystal wafers 81 and 82 are stacked to each other as shown in Fig. 12A. Each of the crystal wafers 80 to 82 is first aligned and their parallelism is adjusted. Then their bonding surfaces are stuck together and temporarily bonded with a smaller pressure than one applied for the subsequent step of full-fledged bonding. Then the parallelism of the crystal wafer stack 84 thus structured is preferably readjusted. The wafers are then bonded in a full-fledged manner by pressurizing them from above and below. The temporary bonding and full-fledged bonding are carried out by diffusion bonding of the top layers of Au of the metal thin films.

The plasma treatment is carried out with the above-mentioned SWP RIE plasma treatment device as described above. The plasma treatment device generates a plasma with microwaves of 13.56 MHz to 2.45 GHz, for example, thereby exciting the reactive gas introduced into the treatment chamber and generating an active species of the reactive gas. According to the present embodiment, Ar gas, CF₄ gas, N₂ gas, O₂ gas, or a mixed gas of O₂ and N₂ is used as the reactive gas. Other treatment conditions are as follows: an output of the high-frequency power source that applies a voltage to the treatment stage is 2.5 kW, a discharge pressure of the reactive gas is 10 to 1 Pa, a temperature of the stage is at about room temperature, i.e., 25 degrees centigrade, and radiation time is for 30 to 60 seconds.

This plasma treatment exposes the surfaces of the wafers to the active species of the reactive gas that evenly activates the surfaces. In other words, organic and contaminating substances, or other wastes are etched and removed from the surfaces of the metal thin films and conductive films included in the bonding surfaces of the crystal wafers 80 to 82 with ions contained in the plasma. Moreover, surfaces are modified by radicals contained in the plasma such that they are easily directly bonded. The SWP RIE plasma treatment device can carry out this two-stage plasma treatment in its same chamber consecutively.

The crystal wafer stack 84 that has been temporarily bonded are evenly pressurized at a pressure of about 39.2 N per square centimeter, for example, so that the bonding surfaces are integrally, firmly, and airtightly bonded. Here, bonding at a relatively low temperature about 200 to 250 degrees centigrade, which has no effect on the characteristics of the crystal resonator element, can provide larger bonding strength. According to the present embodiment, since the top layer of Au of each bonding surface is provided to a thickness of 5000 Å or more, it is possible to provide desirable bonding with high air-tightness of a leak of 1 x 10⁻¹⁴ std·cc/sec or higher, which is necessary for vacuum sealing of the tuning-fork crystal resonator, for example, in a short period of time of about 10 minutes. The stack may be pressurized with a publicly known hydraulic or pneumatic device, and may be pressurized while applying supersonic vibration. The temporary bonding and full-fledged bonding of the crystal wafers can be also carried out in an atmospheric pressure, in a desirable inert-gas atmosphere, or in vacuum. In particular, to seal the crystal resonator element 55 in the cavity 66 in high vacuum, it is heated at about 200 to 250 degrees centigrade, followed by vacuum suction for a short period of time of about 20 to 30 minutes to achieve a degree of vacuum of about 10⁻⁵ Torr.

Subsequently, the crystal wafer stack 84 that has been bonded is divided into pieces by dicing, for example, along the outer lines 85 of the crystal resonator that run horizontally and vertically at right angles as shown in Fig. 12B. Providing the external electrodes 72 and 73 on the bottom surface of the lower substrate 54 by sputtering, for example, to the wafer stack before dicing can simplify the process. Since each crystal resonator obtained by dividing the stack into pieces has the upper and lower substrates 53 and 54 that are transparent, it is easily irradiated with laser light, for example, from the outside, thereby adjusting its frequency. Each crystal resonator whose frequency has been adjusted is placed in a vacuum atmosphere to airtightly block the sealing hole 74, which completes the crystal resonator 51 shown in Fig. 7.

Also according to the present embodiment, it is possible to measure or adjust the frequency of the crystal resonator 51, or carry out a desired test, before dividing the crystal wafer stack 84 into pieces. In this case, the intermediate crystal wafer 80 is patterned in a way that the conductive material of the upper conductive film 59, the lower conductive film 61, and the extraction conductive film 63 provided on the upper and lower surfaces of the outer frame 6 of each adjacent crystal resonator is removed along the outer lines 85 of each crystal resonator and by the width of dicing lines. Accordingly, the excitation electrode of one crystal resonator 51 is electrically independent from another excitation electrode of an adjacent crystal resonator in the crystal wafer stack 84, making it possible to carry out a characteristic test of each crystal resonator and measure and adjust its frequency. In addition, since the upper conductive film 59, the lower conductive film 61, and the extraction conductive film 63 that have been thus patterned are exposed to the side of each crystal resonator 51 obtained by dividing the stack into pieces, it is possible to prevent moisture from coming into the gap between the bonding surfaces of the substrates at dicing, which may result in electrode corrosion.

In another embodiment, the three crystal wafers 80 to 81 can be bonded one by one as shown in Fig. 13. Referring to Fig. 13A, the intermediate crystal wafer 80 and the lower crystal wafer 82 are stuck together for temporary bonding. Here, a protective substrate is placed on the intermediate crystal wafer 80 in a way that its surface not containing metal abuts the bonding surface on the upper surface of the wafer to maintain the wafer's surface roughness. This temporary bonding can be carried out simply by sticking the two wafers together, or by pressurizing them with a smaller pressure than one applied to bond the upper crystal wafer 81 in the subsequent step. Referring now to Fig. 13B, the upper crystal wafer 81 is stacked in alignment with the upper surface of the intermediate crystal wafer 80 and pressurized to be bonded with a pressure almost as large as one applied in the full-fledged bonding in Fig. 12.

In the present embodiment, the frequency of each crystal resonator element can be adjusted in the state shown in Fig. 13A with the two crystal wafers bonded. In this case, the intermediate crystal wafer 80 is patterned in a way that the conductive material of the upper conductive film 9, the lower conductive film 11, and the extraction conductive film 13 of each crystal resonator is removed along the outer lines 85 of each crystal resonator and by the width of dicing lines, so that the excitation electrode of one crystal resonator 1 is electrically independent from an adjacent crystal resonator.

The frequency adjustment can be carried out simultaneously with the plasma treatment of the bonding surface on the upper surface of the intermediate crystal wafer 80 with the above-mentioned plasma treatment device. Since frequency fluctuations of the crystal resonator element 55 due to plasma radiation can be measured by, for example, a test in advance, an electrode film on its surface can be provided to a thickness that copes with the amount of plasma radiation. Here, the plasma radiation is carried out with higher energy than one applied in the plasma radiation provided for the intermediate crystal wafer 80 before being temporarily bonded to the lower crystal wafer 82. The frequency adjustment can be also carried out by laser light radiation, for example.

According to each embodiment of the invention, each bonding surface of the intermediate crystal plate and the upper and lower substrates can be covered with a thin film of SiO₂ In the first embodiment, a thin film of SiO₂ is provided to both the upper and lower surfaces of the outer frame 6 of the intermediate crystal plate 2, and further to each bonding surface of the upper and lower substrates 3 and 4 optionally. Accordingly, the intermediate crystal plate 2 and the upper and lower substrates 3 and 4 are airtightly bonded by direct bonding between the SiO₂ thin films and the crystal surfaces or direct bonding between the SiO₂ thin films, instead of direct bonding between the conductive films and the crystal surfaces. In this case, the above-described plasma treatment for each bonding surface is provided for the surfaces of the SiO₂ thin films after the films are provided.

In the second embodiment, a thin film of SiO₂ is provided to both the upper and lower surfaces of the outer frame 56 of the intermediate crystal plate 52, and further to each bonding surface of the upper and lower substrates 53 and 54 optionally. Accordingly, the intermediate crystal plate 52 and the upper and lower substrates 53 and 54 are airtightly bonded by direct bonding between the SiO₂ thin films and the metal thin films or direct bonding between the SiO₂ thin films, instead of direct bonding between the conductive films and the metal thin films. In this case, the above-described plasma treatment for each bonding surface is provided for the surfaces of the SiO₂ thin films after the films are provided.

Further according to the invention, an intermediate piezoelectric substrate to which a tuning-fork piezoelectric resonator element and an outer frame made of a piezoelectric material other than crystal are integrally formed can be used, instead of the intermediate crystal plate in the above-described embodiments. In this case, the upper and lower substrates can be made of the same piezoelectric material or another piezoelectric material having a thermal expansion coefficient that is comparatively close to that of the above material.

The invention is also applicable to a crystal resonator operating at a thickness-shear vibration mode, instead of the tuning-fork crystal resonator, in the same manner. In this case, particularly when the intermediate crystal plate and the upper and lower substrates are made of AT-cut crystal plates, it is preferable from the view point of thermal expansion coefficients that they be bonded in a way that they are in the same plane direction. Since the vacuum sealing inside the cavity is unnecessary, it is possible to omit the sealing hole in the lower substrate.

It is understood that the invention is not limited to the preferred embodiments and examples described above, and various modifications and changes can be made within the spirit and scope of the invention as is well known to those skilled in the art. For example, the plasma treatment for surface activation can be carried out not only by the above-mentioned SWP RIE method with the slot antenna, but also by other publicly known methods, such as an atmospheric pressure plasma method.

## Claims

1. A piezoelectric resonator, comprising:
an intermediate piezoelectric substrate to which a piezoelectric resonator element and an outer frame are integrally formed, at least one of an upper surface and a lower surface of the outer frame being provided with a conductive film; and
an upper substrate and a lower substrate bonded to the upper surface and the lower surface, respectively, of the outer frame of the intermediate piezoelectric substrate;
the piezoelectric resonator element being suspended in a cantilever manner in a cavity defined by the intermediate piezoelectric substrate and the upper and lower substrates and airtightly sealed,
each bonding surface of the upper and lower substrates and the intermediate piezoelectric substrate being mirror-polished and plasma-treated for surface activation and then being directly stacked to be airtightly bonded.

2. The piezoelectric resonator according to Claim 1, the upper and lower substrates being made of a piezoelectric material.

3. The piezoelectric resonator according to Claim 1, the intermediate piezoelectric substrate being made of crystal.

4. The piezoelectric resonator according to Claim 3, the upper and lower substrates being made of crystal.

5. The piezoelectric resonator according to Claim 3, the upper and lower substrates being made of one of a glass material and silicon.

6. The piezoelectric resonator according to any of Claims 1 through 5,
the upper and lower surfaces of the outer frame of the intermediate piezoelectric substrate being provided with a conductive film,
each bonding surface of the upper and lower substrates being provided with a metal thin film,
the conductive film provided to the outer frame and the metal thin film provided to the upper and lower substrates having a top layer made of Au, and
the outer frame of the intermediate piezoelectric substrate and the upper and lower substrates being airtightly bonded by diffusion bonding.

7. A method for manufacturing a piezoelectric resonator, comprising:
providing an intermediate piezoelectric substrate to which a piezoelectric resonator element and an outer frame are integrally formed, at least one of an upper surface and a lower surface of the outer frame being provided with a conductive film;
providing an upper substrate to be bonded to an upper surface of the intermediate piezoelectric substrate;
providing a lower substrate to be bonded to a lower surface of the intermediate piezoelectric substrate;
mirror-polishing each bonding surface of the upper and lower substrates and the intermediate piezoelectric substrate;
providing each mirror-polished bonding surface of the upper and lower substrates and the intermediate piezoelectric substrate with plasma treatment for surface activation; and
stacking the upper and lower substrates on the upper and lower surfaces of the intermediate piezoelectric substrate in a way that the piezoelectric resonator element is suspended in a cantilever manner in a cavity defined by the substrates, and pressurizing and directly bonding the substrates to airtightly bond the substrates.

8. The method for manufacturing a piezoelectric resonator according to Claim 7,
the upper and lower surfaces of the outer frame of the intermediate piezoelectric substrate being provided with a conductive film,
each bonding surface of the upper and lower substrates facing the intermediate piezoelectric substrate being provided with a metal thin film,
each conductive film provided to the outer frame and each metal thin film provided to the upper and lower substrates having a top layer made of Au with a thickness of 5000 Å or more, and
the outer frame of the intermediate piezoelectric substrate and the upper and lower substrates being airtightly bonded by diffusion bonding.

9. The method for manufacturing a piezoelectric resonator according to Claim 7 or 8, the upper and lower substrates being made of a piezoelectric material.

10. The method for manufacturing a piezoelectric resonator according to Claim 7 or 8, the intermediate piezoelectric substrate being made of crystal.

11. The method for manufacturing a piezoelectric resonator according to any of Claims 7 through 10, further comprising:
providing an intermediate piezoelectric wafer including the intermediate piezoelectric substrate in a plural number;
providing an upper wafer in which the upper substrate is provided in a plural number correspondingly to the intermediate piezoelectric substrate included in the intermediate piezoelectric wafer;
providing a lower wafer in which the lower substrate is provided in a plural number correspondingly to the intermediate piezoelectric substrate included in the intermediate piezoelectric wafer;
mirror-polishing each bonding surface of the intermediate piezoelectric wafer and the upper and lower wafers;
providing each mirror-polished bonding surface of the intermediate piezoelectric wafer and the upper and lower wafers with plasma treatment for surface activation;
stacking the upper and lower wafers on upper and lower surfaces of the intermediate piezoelectric wafer and pressurizing the wafers to integrally bonding the wafers; and
dividing a wafer stack that has been bonded into individual piezoelectric resonators.

12. The method for manufacturing a piezoelectric resonator according to Claim 11, in providing the intermediate piezoelectric wafer, a conductive film provided to a portion on at least one of the upper and lower surfaces of the intermediate piezoelectric wafer corresponding to the outer frame of each intermediate piezoelectric substrate being patterned to be divided along a cutting line for dividing the wafer stack into individual piezoelectric resonators and with a gap equal to a width of the cutting line.

13. The method for manufacturing a piezoelectric resonator according to any of Claims 7 through 12, the upper and lower substrates being stacked and temporarily bonded to upper and lower surfaces of the intermediate piezoelectric substrate and then the upper and lower surfaces of the wafer stack being pressurized to be airtightly bonded.

14. The method for manufacturing a piezoelectric resonator according to any of Claims 7 through 12, after stacking and bonding one of the lower and upper substrates to one of the lower and upper surfaces of the intermediate piezoelectric substrate, the other of the lower and upper substrates being stacked to one of the upper and lower surfaces of the wafer stack and pressurized to be airtightly bonded.

15. The method for manufacturing a piezoelectric resonator according to Claim 14, further comprising:
adjusting a frequency of the piezoelectric resonator, after stacking and bonding one of the lower and upper substrates to one of the lower and upper surfaces of the intermediate piezoelectric substrate, and before bonding the other of the lower and upper substrates to one of the upper and lower surfaces of the wafer stack.

16. The method for manufacturing a piezoelectric resonator according to Claim 15, a frequency of the piezoelectric resonator being adjusted simultaneously with surface activation of one of the upper and lower surfaces of the wafer stack by providing one of the upper and lower surfaces of the wafer stack with plasma treatment before bonding the other of the lower and upper substrates.

17. The method for manufacturing a piezoelectric resonator according to Claim 7, the intermediate piezoelectric substrate and the upper and lower substrates being bonded at room temperature.

18. The method for manufacturing a piezoelectric resonator according to Claim 7 or 8, the intermediate piezoelectric substrate and the upper and lower substrates being bonded while being heated.

19. The method for manufacturing a piezoelectric resonator according to Claim 18, heating being carried out at 200 to 250 degrees centigrade.

20. A piezoelectric resonator manufactured by the method according to any of Claims 7 through 19.
